# EUROPEAN PATENT APPLICATION

(11) **EP 1 818 983 A2**
(43) Date of publication of application: **15.08.2007**
(21) Application number: 07000897.4
(22) Date of filing: 17.01.2007
(51) Int. Cl.: H01L 23/495

(54) **Three phase inverter power stage and assembly**

(30) Priority: 17.01.2006 US 759500 P; 17.01.2006 US 759499 P; 16.01.2007 US 623520
(71) Applicant: INTERNATIONAL RECTIFIER CORPORATION, El Segundo, CA 90245 (US)
(72) Inventor: Bones, Norbert, 41334 Nettetal (DE); Rachmann, Klaus, 47809 Krefeld (DE); Hannig, Michael, 47798 Krefeld (DE); Thor, Volker, 45279 Essen (DE); Kienitz, Stefan, 40233 Düsseldorf (DE); Pallasvirta, Markus, 40885 Ratingen (DE)
(74) Representative: Kopf, Korbinian Paul

(57) **Abstract**

A three phase invertor has five coplanar leadframes for 2 d-c terminals and 3 a-c terminals. Power MOSFETs soldered around the periphery of one of the d-c leadframes are wire bonded to adjacent ones of the 3 a-c leadframes which are mounted alongside the two edges and an end of one of the d-c leadframes. Further switching die are soldered to the 3 a-c leadframes and wire bonded to the other d-c leadframe. The die are spaced along and follow a general U-shaped path. The leadframes are mounted on a heat sink which receives an insulation spacer and cap to form a hermetically sealed volume around the leadframes and die. The heat sink has cavities to mount bus capacitors and has a water cooling channel which follows and is below the U-shaped path of the die.

## Description

### RELATED APPLICATIONS

The present application is based on and claims benefit of U.S. Provisional Application No. 60/759,500, filed January 17, 2006, entitled THREE-PHASE INVERTER FOR AUTOMOTIVE APPLICATIONS (IR-3119 Prov), and U.S. Provisional Application No. 60/759,499, filed January 17, 2006, entitled NOVEL REALIZATION OF A PLANAR POWER STAGE (IR-3120 Prov), to all of which a claim of priority is hereby made and the disclosure of which is incorporated by reference.

### FIELD OF THE INVENTION

This invention relates to electrical power supplies and more specifically relates to a three phase inverter which can be employed in an automotive or other application.

### BACKGROUND OF THE INVENTION

Multiphase inverter circuits and assemblies are well known and are shown for example in U.S. patents 5,966,291; 6,320,747; 6,326,761; 6,700,191 and 6,703,703. Such devices generally employ leadframes which carry MOSFETs, IGBTs or other switching devices arranged in a three phase bridge and assembled in sealed housings which may be air or water cooled. Such circuits are needed for many applications, such as automotive applications for producing a three phase a-c output from the d-c automotive battery for driving three phase motors or the like.

Such devices must be able to operate reliably and withstand the heat, vibration and mechanical shock environment of an automotive application. Further, the circuit and its housing should be low cost, low volume, and easily installed and maintained.

The leadframe assemblies in the prior art have a number of drawbacks. Thus:
1. For leadframes molded into plastic and used as a carrier for semiconductor devices as in patent 6,703,703 only process temperatures up to the glass transition temperature of the plastic are permissible. This rules out the use of interconnection processes for the semiconductor devices that require higher temperatures.
2. In the assembly of a power module with a plurality of semiconductor switches it is often the case that the power stage configuration can be tested only after the elements (e.g. heat-sink, bus capacitor, etc.) have been assembled. This often increases the value yield loss during manufacturing.
3. Semiconductor power stages often have high stray inductance due to the complex circuit routing necessary to realize the power stage topology.
4. For the realization of given power stage configurations, multilayer leadframe bus structures are often required. These bus structures have to be produced in a complicated manufacturing process.
5. The topology and the routing of power stage configurations often lead to many interconnections between semiconductor devices and the outer terminals of the power configuration.
6. Multiple phase bridge configurations often require placing the semiconductor devices in a complicated layout pattern. Therefore, the cooling has to be either underneath the entire area of the configuration or it has to follow this layout pattern.

The packaging of such leadframe assemblies has also had a number of problems.

The two conventional methods of packaging for an inverter have been the use of discrete components and the use of a power substrates.
1. An inverter employing discrete components has the disadvantage of size, operational temperatures and permissible process temperatures. The discrete components have their own packages which increases the size of the three phase bridge considerably. It also does not allow the same maximum junction temperatures compared to bare semiconductor devices. Furthermore, the permissible maximum process temperature is greatly reduced due to the limited temperature capability of the molding plastic of the discrete components. This can compromise performance and reliability.
2. An inverter using a power substrate is significantly more costly. The substrate adds to the thermal stack and increases thermal resistance from the semiconductor device to the coolant. It also increases the total number of necessary interconnections which reduces reliability.

### SUMMARY OF THE INVENTION

A novel leadframe assembly is provided in which a plurality of individual insulated leadframes; B(-); B(+) and three ac leadframes as for phases U, W and V are provided and located in a common plane. These leadframes carry a plurality of semiconductor devices using an insulated circuit board glued to selected leadframes as a mechanical interconnection element having also the function of routing electrical signals from one leadframe to the others. This is done after the semiconductor device die have been attached, as by solder, to the insulated frames. Therefore, the processes used for attaching the semiconductor device die are not limited by the glass transition temperature of the insulated circuit board. The invention then allows the assembly of testable sub-modules. Furthermore, this configuration allows the realization of an insulated multilayer bus-structure which provides a layout pattern which permits easy cooling.

A number of advantages flow from this novel assembly of plural coplanar insulated leadframes. Thus:
1. The invention connects leadframes positioned on one plane carrying a plurality of semiconductor devices using an insulated circuit board glued to each leadframe. The gluing process is carried out after the attachment of the semiconductor devices to the leadframes. This allows the use of interconnection processes for the semiconductor devices that require higher temperatures than the glass transition of the insulating element (circuit board). Furthermore, the insulated circuit board can be used as a carrier of electronic components to place control circuitry in close vicinity to the semiconductor devices (e.g. gate driver circuitry).
2. The invention connects leadframes positioned in a common plane and carrying a plurality of semiconductor devices using an insulated circuit board glued to each leadframe. This makes testable sub-configurations before attaching the assembly to a cooling plate or heat-sink. This increases the value yield during manufacturing compared to the conventional methods described above.
3. The invention connects leadframes positioned in one plane carrying a plurality of semiconductor devices using an insulated circuit board glued to each leadframe. Furthermore, central leadframes consist of a double layer stack representing the positive and negative rail of the power stage topology. This planar configuration has extremely low inductance. This is applicable for many power stage topologies including multiple phase bridge configurations.
4. For the realization of power stage configurations, multilayer leadframe bus structures are often required. The invention provides central leadframes that consist of a double-layer stack representing the positive and negative rail of the power stage topology. These two layers consist of metal plates with a given geometry which are attached by an electrically isolating interface material. This material has filler particles such as insulation ceramic particles of a selected size which guarantee a minimum thickness such that accidental electrical contact between the two plates is ruled out for the required system voltage. This method is much more cost-effective than laminated busbars which may be used for this purpose.
5. The invention connects leadframes positioned on one plane carrying a plurality of semiconductor devices using an insulated circuit board glued to each leadframe. The leadframes also function as the outer terminals of the power stage configuration. The semiconductor devices are wire bonded to the respective leadframe according to the desired power stage topology. The invention minimizes the number of interconnections from the semiconductor device to the outer terminal. For the one pole of the semiconductor device the only interconnection is the device attachment to the leadframe (e.g. solder) and for the other pole, the wire bonds to the lead-frame. Therefore, for each pole there is just one interconnection wire bond.
6. In the multiphase bridge configuration the semiconductor devices are placed on leadframes with staggered outlines or current paths. Therefore, the semiconductor devices are positioned in generally straight lines, even if they are placed on different leadframes. This allows straight coolant conducting channels which may extend on a U-shaped path to be used for the cooling of the power stage, which significantly reduces manufacturing costs.
7. The multi-phase bridge configuration permits bending the end region of the leadframe upwards to form upright or angled terminals. In the region of the bending line of the leadframe terminals have a reduced cross-sectional profile to ensure mechanical stability of the bending region after the bending operation.

With respect to the housing of the leadframe, the leadframes are attached to a heat-sink in an insulating manner. The heat-sink contains a liquid cooling channel and the points of fixation or mounting for the inverter. A printed circuit board which is glued on top of the leadframes provides the interconnections for controlling the semiconductor devices. A support frame, placed on top of leadframes and glued and bolted to the heat-sink holds current sensing elements, the controller circuitry board, and fixes the leadframes together. An EMI shield screens the entire power stage and controller. A cover seals the arrangement and provides the fixation of the electrical terminals and connectors.

A number of advantages flow from the novel housing for the composite leadframe assembly. Thus:
1. It provides a low cost structure.
2. The invention provides a very good thermal attachment for the necessary bus capacitors. Furthermore, it enables electrical interconnection with very low stray inductance, which is important for the safe operation of the inverter and low EMI levels.
3. The sensing of the phase currents is located directly at the phase leadframes with a very compact packaging..
4. A support frame with multiple functions is included into the design. It secures the sub-module during the manufacturing process. Further, it enables the semiconductor devices to be potted by creating a shallow cavity, it holds and secures the control circuitry of the inverter, it holds the current sense elements and filter rings, and it can provide additional fixation of the phase and bus leadframes.
5. A housing is placed on top of the power stage and control circuitry to provide protection. It seals against the heat-sink and acts also to support an EMI shield, ensuring the electrical connection to the heat-sink.
6. The leadframes are designed to provide local heat capacity for the semiconductor devices. This allows a short term operation of the inverter with powers higher than nominal. During that time, the power dissipated by the semiconductor devices is dumped into the leadframe heat capacities.
7. The cooling channel is placed directly underneath the semiconductor devices, ensuring that the elements with highest power dissipation density are effectively cooled.
8. The cooling channel also provides cooling for the bus capacitors supported in the heat sink and cools hot spot regions of the controller circuitry.

### BRIEF DESCRIPTION OF THE DRAWINGS

Figure 1 is a circuit diagram of the inverter structure of the invention.

Figure 2 is a top plan view of the assembled leadframes of the invention.

Figure 3 is a perspective view of the assembly of Figure 2.

Figure 3A is a detail view of the circled area in Figure 3.

Figure 4 shows the path of the cooling channel in a heat sink beneath the leadframes of Figure 1.

Figure 5 is a plan view of the leadframes of Figure 1 without the die or wire bonds in place to show the substantial coplanarity of the leadframes.

Figure 6 is an exploded perspective view of the leadframes and insulation printed circuit board (PCB) of Figures 1 and 5.

Figure 7 is a detailed top view of a die mounted on a leadframe in Figure 1.

Figure 8 is a cross-section of Figure 7 taken across section line 8-8 in Figure 7.

Figure 8A is a detail showing the bending of a leadframe extension in Figure 8 to form a power terminal which extends perpendicularly from the plane of the leadframe.

Figure 9 is a partly cut-away view of the leadframe assembly of Figures 2 to 8 assembled on a heat sink.

Figure 9A is a detail of the capacitor connection terminals in Figure 9.

Figure 10 is an exploded perspective view of the housing and leadframe assembly.

Figure 11 shows the assembly of Figure 10 without the top cover.

Figure 12 is a cross-section detail of the seal between the cover and heatsink of Figure 10.

Figure 13 and 14 show two respective isometric views of the assembly of Figure 10.

Figure 15 is a cross-sectional detail of the connector bolt of Figures 10, 13 and 14.

### DETAILED DESCRIPTION OF THE DRAWINGS

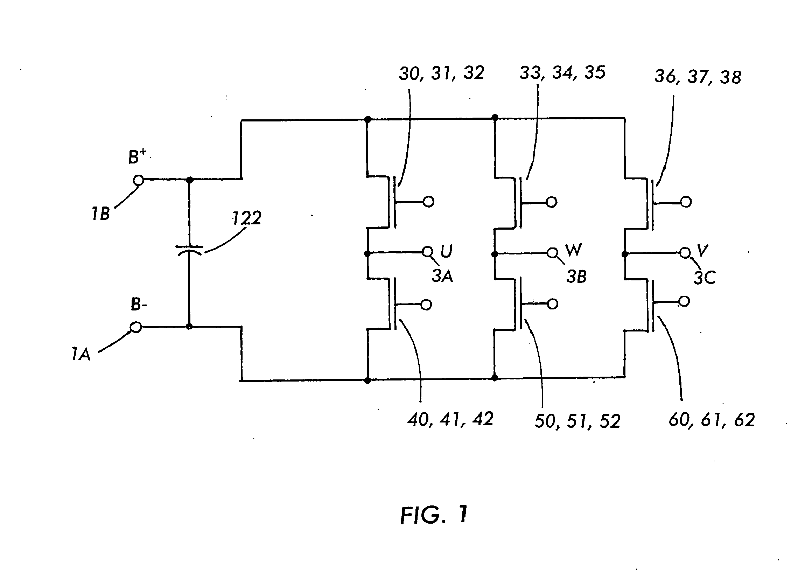

Referring first to Figure 1, there is shown a conventional three phase inverter circuit. The component numbers are those described in the following description as will become apparent. In general, however, the circuit comprises d-c input terminals 1A, 1B and three phase output terminals 3A, 3B and 3C for phases U, W and V respectively. A filter capacitor 122 is connected across the d-c input terminals, and MOSgated semiconductor device switches inlcuding MOSgated devices 30, 40 for phase U, 33, 50 for phase W and 36, 60 for phase V are provided. It will be noted that each leg of the bridge has 3 parallel connected MOSgated devices as will be later described. The invention deals with the novel implementation and packaging of multiphase circuits like that of Figure 1.

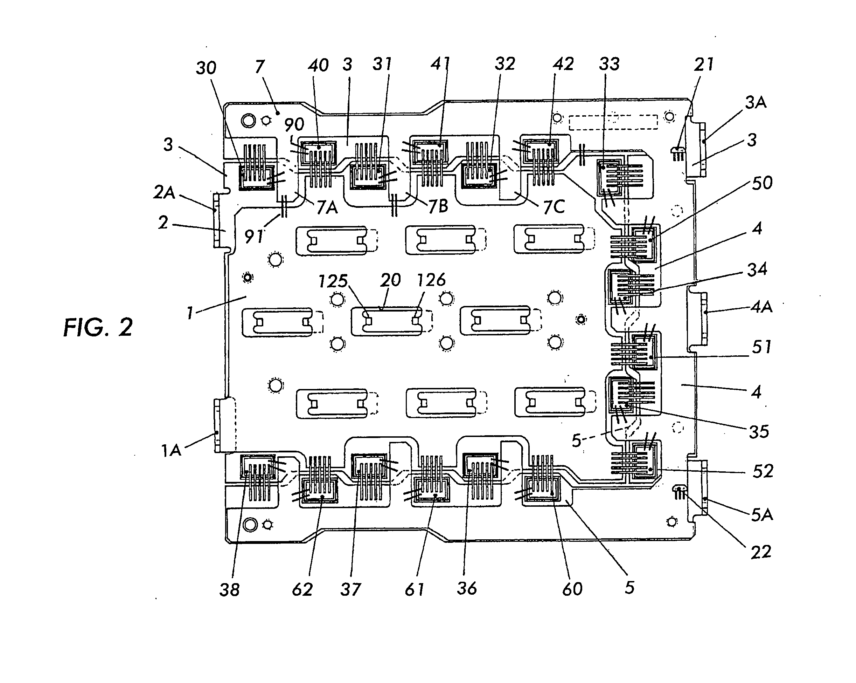

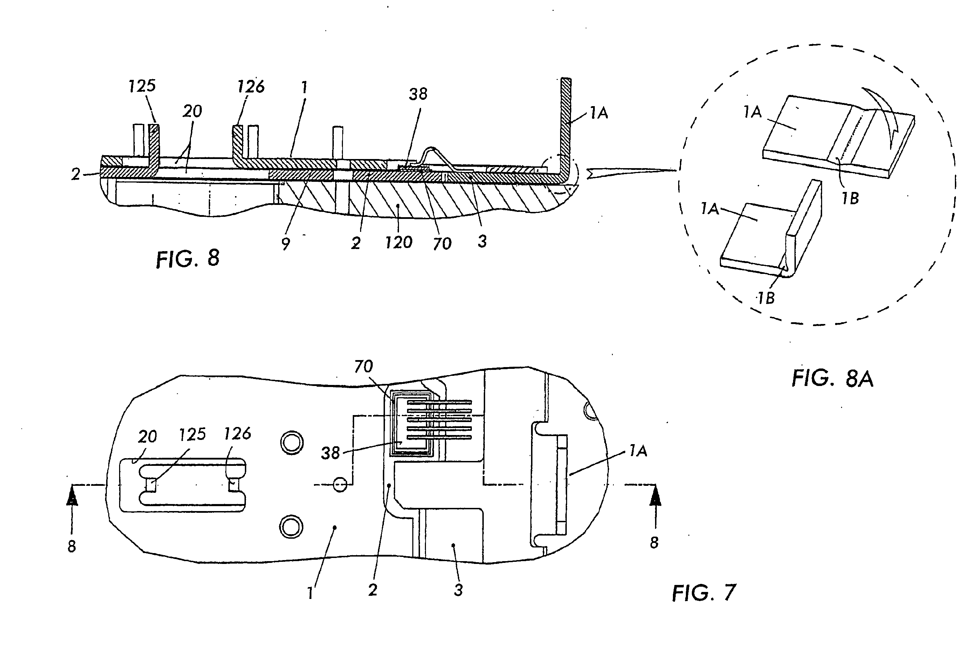

Figures 2 through 8 show a novel leadframe arrangement for carrying out the circuit of Figure 1. Thus, 5 leadframes, insulated from one another and generally coplanar to one another are provided, including B(-) leadframe, B(+) leadframe 2 and AC phase leadframes 3, 4 and 5, corresponding to phases U, W and V respectively. Leadframes 1 to 5 are thin conductive members which may be suitably stamped or etched, to a given pattern using well known techniques. Each of leadframes have perpendicularly extending terminals 1A, 2A, 3A, 4A and 5A, respectively bent upwardly from the flat as shown in Figure 8A for B(+) lead 1A. Note groove 1B in Figure 8 which facilitates the bend.

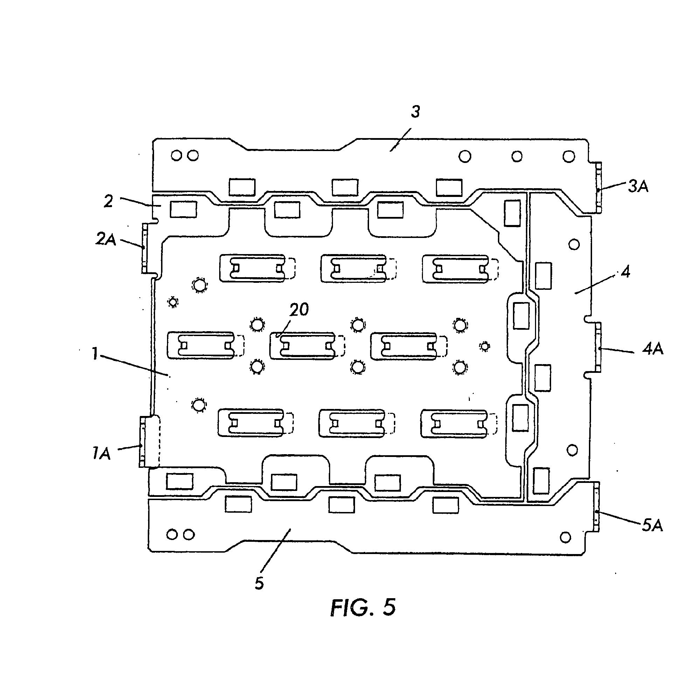

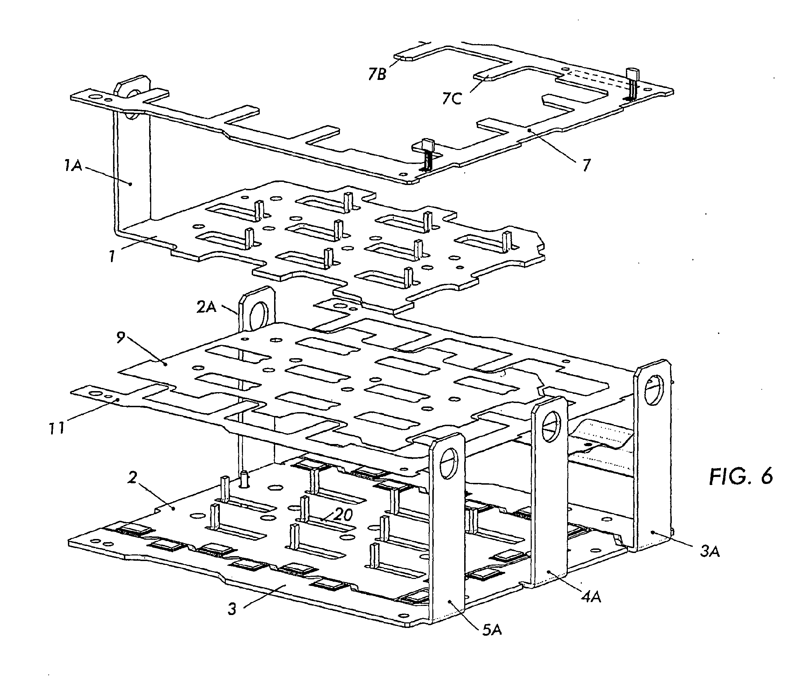

Leadframes 1 and 2 overlap one another as shown in Figure 8 and are secured to one another but insulated from one another by a suitable insulation cement 9 (Figures 6 and 8A) or the like. Leadframes 3, 4 and 5 are located adjacent to but are spaced from the two sides and one edge of the combined leadframes 1 and 2 as may be best seen in Figure 5.

Also shown in Figures 2, 6, 7 and 8 is a printed circuit board 7 which carries the necessary control circuitry and conductive traces leading to the control elements (gate electrodes and current sense circuits) of the various devices mounted on the leadframes as will be described. Circuit board 7 is glued atop the leadframes as by the insulation cement 11 in Figures 6 and 8.

Leadframes 1 and 2 have aligned openings, such as openings 20 which permit passage of capacitor terminals, as will be described. The leadframes also carry Hall-effect sensors, such as sensors 21 and 22 on leadframes 3 and 5 respectively (Figure 2) which are used to monitor the current in phases U, V and W as will be later described.

Each of the leadframes 2, 3, 4 and 5 have MOSgated die such as MOSFET (FEDT) die soldered thereto before the assembly of the leadframes relative to one another.

Thus, as best shown in Figures 2, 3, 7 and 8, nine MOSFETs (3 parallel FETs for each phase) 30 to 38 have their bottom drain electrodes soldered around the periphery of B(+) leadframe 2; three FETs 40, 41, 42 are soldered to leadframe 3; three FETs 50, 51, 52 are soldered to leadframe 4, and three FETs 60, 61, 62 are soldered to leadframe 5.

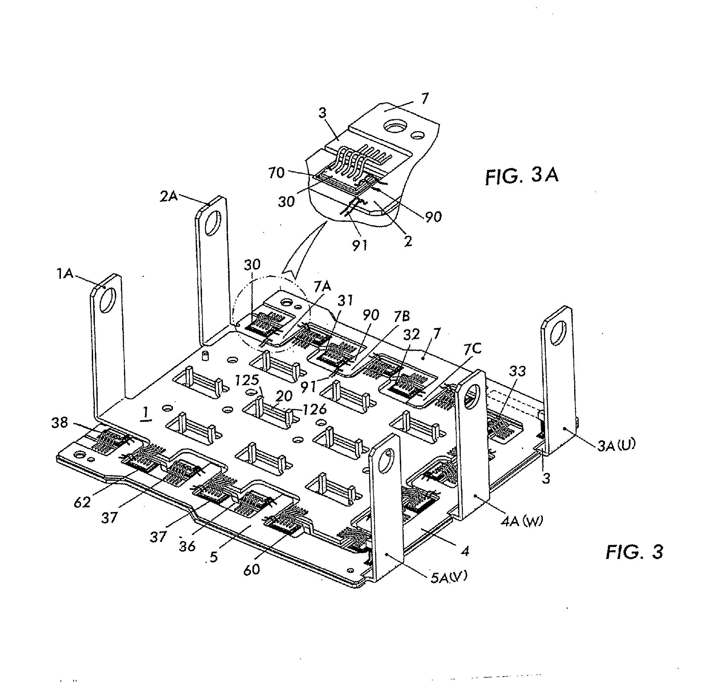

Figures 3A, 7 and 8 show the typical connection of die 38 to leadframe 2, using a conventional heat spreader and solder connection 70.

The source electrodes of all of the FET die are connected to and adjacent one of the phase leadframes 3, 4 and 5 or the B(-) leadframe 1. Thus, in Figures 2 and 3, the sources of FETs 40,41,42, 50, 51, 52 and 60, 61 and 62 are wire bonded to the B(-) leadframe 1. The sources of FETs 30, 31, 32 are bonded to leadframe 3 of phase U. The sources of FETs 33, 34 and 35 are bonded to leadframe 4 (phase W). The sources of FETs 36, 37 and 38 are each bonded to leadframe 5 (phase V).

In order to control the individual FETs, control ICs (not shown) on PCB7 are connected by traces on the PCB 7. Thus, PCB 7 has projection such as projection 7A, 7B, 7C at each FET location which has traces which are wire bonded to the gate electrodes of their respective die as by wire bonds 90 (Figure 3A) and to leadframe 1 as by wire bonds 91 (Figure 3A).

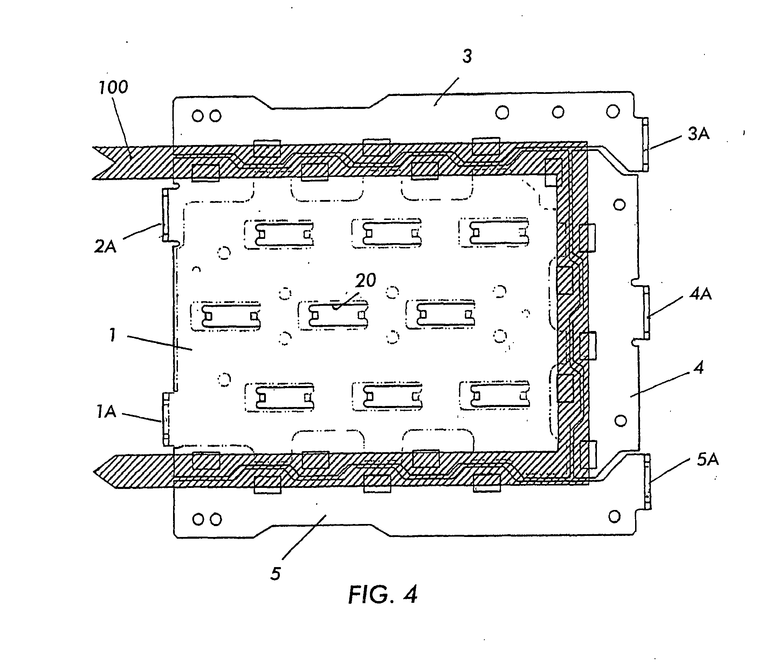

Major benefits of the novel layout of the 5 leadframes are first, it allows the high temperature solder securement of the die to the leadframes, and second, it lays out the FETs in a simple continuous U shape path 100 (shown shaded in Figure 4, which permits an extremely efficient cooling channel in a heat sink to e described to follow the location of the heat-generating die, to enable efficient cooling of the assembly with low cost manufacture.

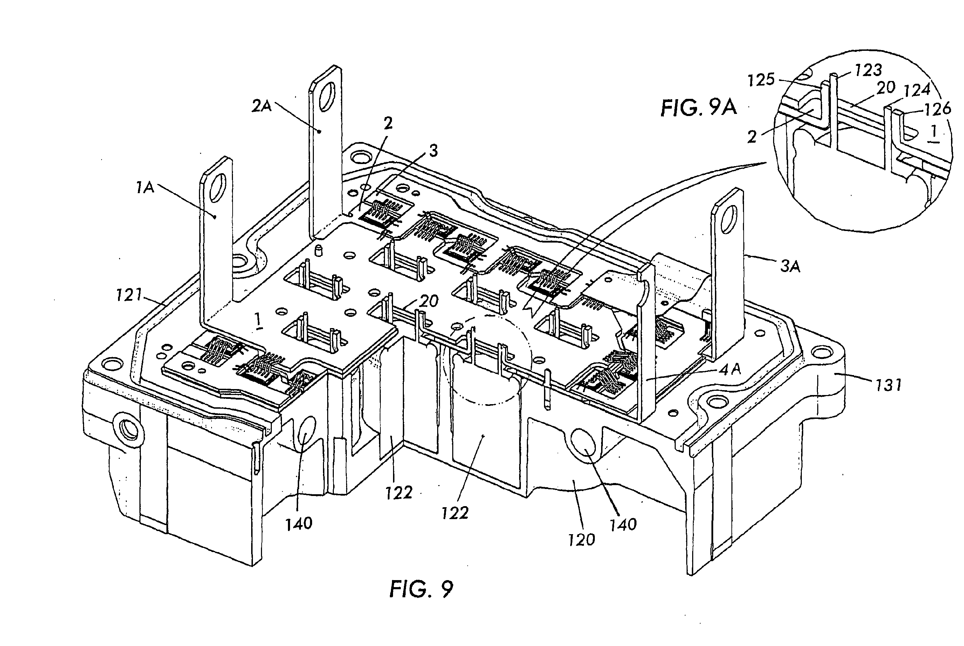

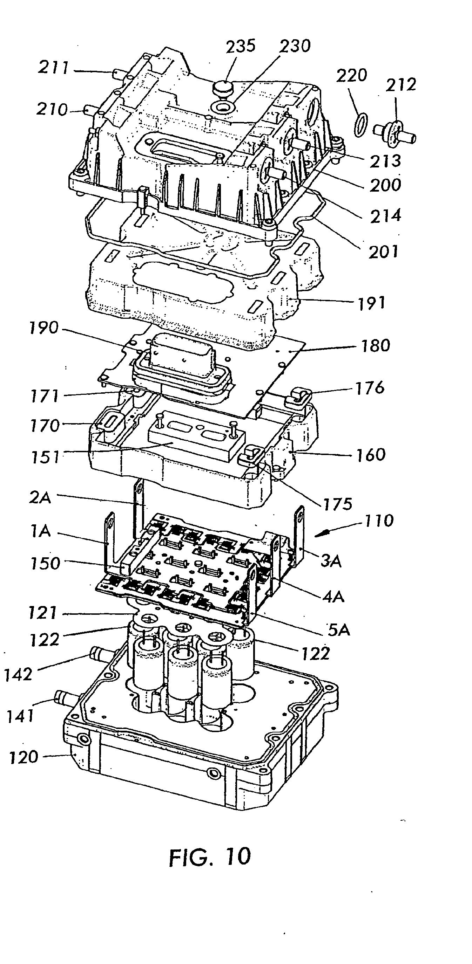

Figures 9 to 15 show the novel housing for the leadframe assembly of Figures 2 through 8. Thus, the assembly of Figures 2 through 8 is shown in Figure 10 as assembly 110. The assembly 110, as shown in Figures 9, 10 and 11, is mounted on a heat sink 120 and is insulated there from by a thin insulation sheet 121. Heat sink 120 contains cavities for mounting 9 capacitors 122. The capacitor terminals 123, 124 (Figure 9A) may extend through openings 20 and spot welded to up-bended projections 125, 126 respectively of the B(-) and B(+) leadframes 2 and 1.

Heat sink 120 also includes suitable mounting flanges 130, 131 and other bolt openings to enable mounting of the fully assembled structure to a motor or generator or the like.

Heat sink 120 further contains a water flow channel 140 which follows the path 100 (Figure 4) under the power FETs or die of the leadframe 110. Channel 140 has coolant inlet and outlet fittings 141 and 142. If desired, the heat sink 120 can be air cooled.

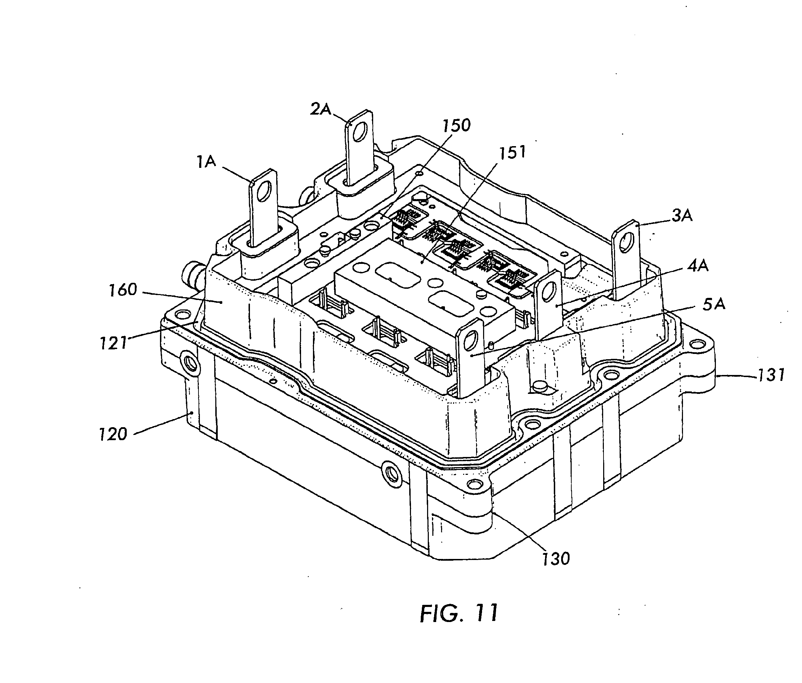

A contact block 150 for PCB 7 is then mounted in place and a spacer 151 is fixed over the surface of assembly 110 (Figures 10 and 11). An insulation frame 160 receives terminals 1A through 5A and is suitably clamped or fixed to heat sink 120. Support frame 160 carries C shaped rings 170 and 171 of magnetic material, which receive terminals 1A and 1B, and C ring magnetic sensors 175, 176 which receive the Hall sensors 22 and 21 respectively of Figure 2. These sensors are employed to measure the inverter currents in the B(-) and B(+) terminals, and phases U, W and V. and can cooperate with circuitry carried on circuit board 180 (Figure 10) and the PCB 7. Spacer 151 helps to prevent excessive vibration of circuit board 180. Connector 150 (Figure 11), which may function as a ground connector, also supports board 180 of Figure 10.

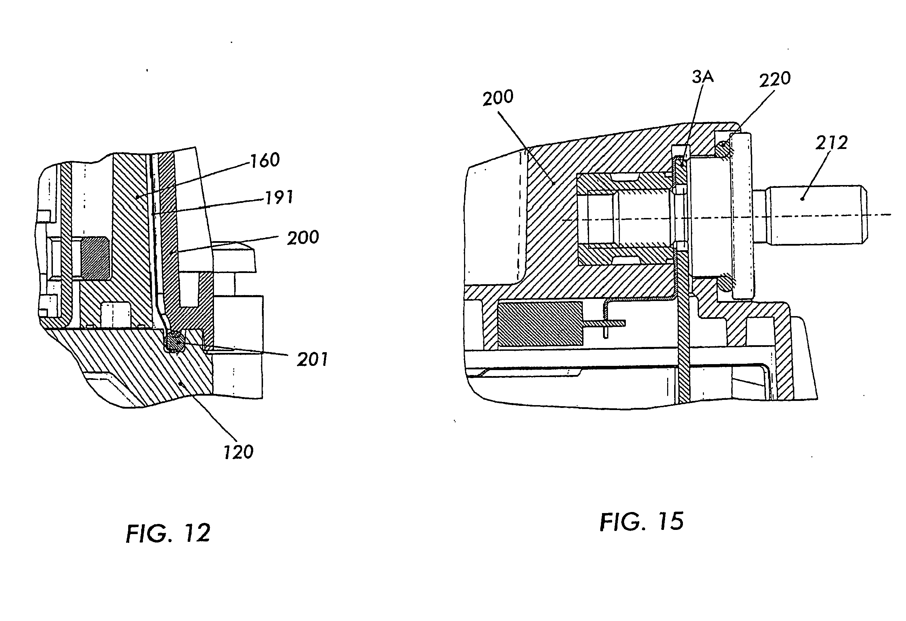

A signal connector structure 190 of Figure 10 is connected to circuit board 180 and is shielded against electromagnetic interference by a suitable shield 191 (Figures 10 and 12). If desired, cover 200 can be of metal, so that EMI shield 191 can be eliminated.

The housing is completed by an insulation cover 200. Cover 200 is suitably fixed to heat sink 120 and is sealed thereto as by an O-ring seal 201 (Figure 12). Cover 200 also receives terminal bolts 210, 211, 212, 213 and 214 for terminals B(-), B(+), phase U, phase W and phase V respectively. These terminal bolts are sealed by O-ring seals such as seal 220 (Figures 10 and 15).

A vent opening 230 in Figure 10 may be provided to enable venting of the module interior and opening 230 can be sealed by cap 235 as desired.

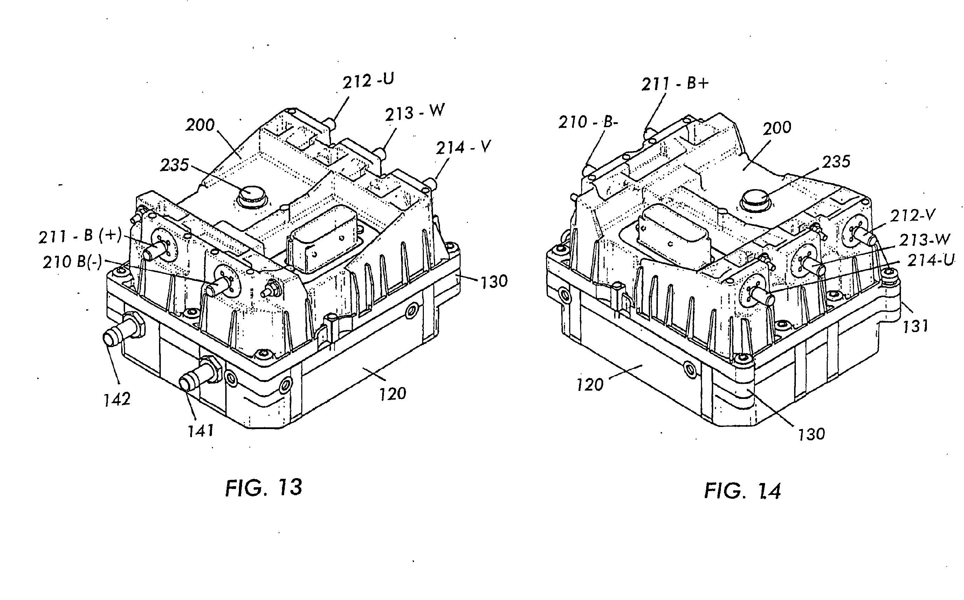

The fully assembled module is shown in Figures 13 and 14.

Although the present invention has been described in relation to particular embodiments thereof, many other variations and modifications and other uses will become apparent to those skilled in the art. It is preferred, therefore, that the present invention be limited not by the specific disclosure herein.

## Claims

1. A power stage for a multiphase converter having two d-c terminals and at least 3 a-c terminals; said planar power stage comprising separate flat leadframes insulated from one another and connected to respective ones of said terminals; each of said flat leadframes being generally co-planar; said leadframes for said two d-c terminals being disposed one atop the other and having a generally rectangular planar shape with first and second sides and first and second ends; said leadframes for said 3 a-c terminals being disposed adjacent said first and second of said sides and one of said ends respectively and being coplanar with said leadframes for said two d-c terminals.

2. The structure of claim 1, wherein said converter is an inverter circuit for converting d-c power to a-c multiphase power.

3. The structure of claim 1, which further includes a first plurality of semiconductor die each having electrodes on their top and bottom surfaces; said first plurality of die having one of their said electrodes soldered to one of said two leadframes of said d-c terminals and spaced from one another and extending adjacent to said first and second sides and said one of said ends, along a general U-shaped path; the other of said electrodes of said first plurality of die being wire bonded to the surfaces of said leadframes of said 3 a-c terminals which are adjacent to said die positions.

4. The structure of claim 1, wherein said die of said first plurality of die are MOSgated switching devices.

5. The structure of claim 4, wherein said converter is an invertor circuit for converting d-c power to a-c multiphase power.

6. The structure of claim 3, which further includes second, third and fourth pluralities of die which are identical to those of said first plurality of die each of said second, third and fourth pluralities of die being spaced along and having one of their electrodes soldered to respective ones of said leadframes for said three a-c terminals and having their other electrode wire bonded to an adjacent surface location on said other of said two d-c terminal leadframes; said die of said second, third and fourth pluralities of die being located to each be generally laterally between respective pairs of die of said first plurality of die, whereby all of said die of all of said pluralities are spaced along a U-shaped path.

7. The structure of claim 6, wherein said converter is an inverter circuit for converting d-c power to a-c multiphase power.

8. The structure of claim 6, wherein all of said die of all of said pluralities of die are MOSgated switching devices.

9. The structure of claim 8, wherein said converter is an inverter circuit for converting d-c power to a-c multiphase power.

10. The structure of claim 8, which further includes a printed circuit board fixed atop said power stage and generally coplanar therewith for applying control signals to the gates of each of said die.

11. The power stage of claim 3, which further includes a thermally conductive heat sink positioned beneath and supporting and in thermal communication with said leadframes and die.

12. The device of claim 11, wherein said heat sink has a cooling fluid channel therein; said channel having a U-shape which is disposed beneath and in thermal communication with each of said die.

13. The structure of claim 12, wherein said die of said first plurality of die are MOSgated switching devices.

14. The power stage of claim 6, which further includes a thermally conductive heat sink positioned beneath and supporting and in thermal communication with said leadframes and die.

15. The device of claim 14, wherein said heat sink has a cooling fluid channel therein; said channel having a U-shape which is disposed beneath and in thermal communication with each of said die.

16. The device of claim 1, wherein each of said flat leadframes has an upwardly bent terminal portion at a general right angle to the plane of said leadframes.

17. The device of claim 3, wherein each of said flat leadframes has an upwardly bent terminal portion at a general right angle to the plane of said leadframes.

18. The device of claim 6, wherein each of said flat leadframes has an upwardly bent terminal portion at a general right angle to the plane of said leadframes.

19. The device of claim 10, wherein each of said flat leadframes has an upwardly bent terminal portion at a general right angle to the plane of said leadframes.

20. The device of claim 11, which further includes at least one bus capacitor connected across said d-c terminals; said heat sink having a cavity therein for receiving the body of said capacitor; said capacitor having first and second terminals connected to said first and second d-c terminal leadframes respectively.

21. The device of claim 15, which further includes at least one bus capacitor connected across said d-c terminals; said heat sink having a cavity therein for receiving the body of said capacitor; said capacitor having first and second terminals connected to said first and second d-c terminal leadframes respectively.

22. A multiphase invertor assembly; said multiphase invertor assembly comprising a power stage consisting of a plurality of coplanar leadframes insulated from one another; a plurality of semiconductor switching devices connected to selected ones of said leadframes; a heat sink for receiving said power stage and in thermal communication with said plurality of semiconductor switching devices, an insulation frame enclosing the sides of said plurality of insulated leadframes, and a top cap fastened to said leadframe and in contact with said insulation frame and hermetically enclosing said leadframes and die in said enclosed volume; said plurality of leadframes each having a terminal extending through said cap.

23. The assembly of claim 22, wherein said semiconductor switching devices are spaced from one another along a generally U-shaped path; said heat sink having a water cooling channel therein which is generally U-shaped and which is follows said U-shaped path of said switching devices.

24. The assembly of claim 22, wherein said heat sink has at least one cavity therein; and a d-c bus capacitor mounted within said one cavity and connected to a selected path of said leadframes.
